# FASCICULE DE BREVET EUROPEEN

(11) **EP 0 840 247 B1**
(45) Date de publication et mention de la délivrance du brevet: **18.08.2004**
(21) Numéro de dépôt: 97402578.5
(22) Date de dépôt: 30.10.1997
(51) Int. Cl.: G06K 7/06, H05K 5/02, G06K 19/077

(54) **Modem radio équipé d'un lecteur de carte à mémoire**
Mit einem Speicherkartenleser versehenes Funkmodem
Radio modem equipped with a memory card reader

(30) Priorité: 04.11.1996 FR 9613397
(43) Date de publication de la demande: 06.05.1998
(73) Titulaire: ALCATEL, 75008 Paris (FR)
(72) Inventeur: Torlotin, Thierry, 92100 Boulogne (FR)
(74) Mandataire: El Manouni, Josiane

(56) Documents cités:
- EP-A- 0 610 025
- EP-A- 0 657 834
- WO-A-96/26479
- DE-U- 29 505 678

## Description

La présente invention concerne un modem radio équipé d'un lecteur de carte à mémoire.

On rappelle qu'un modem radio est un dispositif permettant de transmettre par voie radio des données issues d'un appareil tel que notamment un ordinateur personnel, ou PC (pour "Personal Computer").

Un exemple d'application de la présente invention consiste dans la transmission, via un système de radiocommunications mobiles tel que notamment le système GSM (pour "Global System for Mobile communications"), de données issues d'un appareil tel que notamment un ordinateur portable.

Dans un système tel que le système GSM par exemple, il est connu de munir les terminaux mobiles de lecteurs de cartes à mémoire, appelées aussi, dans le système GSM, cartes SIM (pour "Subscriber Identity Module"), ce qui permet notamment d'identifier les utilisateurs de ces terminaux mobiles afin de contrôler leur accès aux services procurés par ce système.

Par lecteur de carte à mémoire on entend ici un dispositif réalisant les fonctions aussi bien mécaniques qu'électriques nécessaires à la préhension de la carte et à la lecture des informations mémorisées dans cette carte.

Il est ainsi connu d'équiper les téléphones portables GSM de lecteurs de cartes SIM.

Il est connu du document DE 29505678U de munir un modem radio GSM destiné à équiper un appareil tel que notamment un ordinateur portable, d'un lecteur de carte SIM.Ces modems radio GSM étant eux-mêmes généralement réalisés sous la forme d'une carte destinée à être insérée dans une fente prévue dans ledit appareil ( cette carte étant dite ici carte d'équipement pour la distinguer de ladite carte à mémoire, d'épaisseur sensiblement inférieure) il n'est d'ailleurs pas évident de prévoir un lecteur de carte à mémoire dans une telle carte d'équipement.

A titre d'exemple de carte d'équipement on citera les cartes de type PCMCIA (pour "Personal Computer Memory Card International Association"), ayant une longueur et une largeur analogues à celles d'une carte à mémoire de type carte de crédit, et une épaisseur qui peut être égale à 5 mm ou à 10,5 mm, suivant qu'il s'agit d'une carte PCMCIA dite de type II ou d'une carte PCMCIA dite de type III.

Il est ainsi connu de réaliser un modem radio sous forme de carte PCMCIA de type III, et donc de prévoir dans l'appareil destiné à être équipé de ce modem une fente ayant des dimensions, et notamment une hauteur, adaptée à la réception de ce type de carte.

Le document EP-A-0610025 décrit une carte apte à être repliée sur elle-même et qui, à l'état replié, a une épaisseur équivalente à celle d'une carte PCMCIA de type III ou IV, et à l'état non replié, une épaisseur équivalente à celle d'une carte PCMCIA de type I ou II.

Il est aussi connu, lorsque les composants correspondant à la partie radio proprement dite de la fonction modem (par opposition aux parties conversion de fréquence et traitement en bande de base) sont trop volumineux pour pouvoir être logés dans ladite carte, de les loger dans un module distinct revêtant la forme d'une excroissance de ladite carte, dépassant de ladite fente à l'état inséré dudit modem.

La présente invention a notamment pour but de permettre à un modem radio réalisé selon le concept de carte d'équipement, notamment de carte de type PCMCIA, de pouvoir être muni d'un lecteur de carte à mémoire telle que notamment une carte SIM.

La présente invention a ainsi pour objet un modem radio destiné à équiper un appareil tel que notamment un ordinateur portable, ledit modem étant destiné à être inséré dans une fente prévue dans ledit appareil, ledit modem étant réalisé sous forme d'une carte dite carte d'équipement d'épaisseur déterminée et adaptée aux dimensions de la fente de l'appareil, la carte d'équipement d' épaisseur déterminée comportant deux éléments chacun réalisé au moyen d'une carte d'équipement d'épaisseur inférieure à ladite épaisseur déterminée et ledit modem étant essentiellement caractérisé en ce que les deux éléments sont d'une part disposés l'un par rapport à l'autre, et d'autre part équipés, de manière à former dans l'espacement (e) entre les éléments un lecteur de carte à mémoire,

Suivant une autre caractéristique, ladite épaisseur déterminée est celle d'une carte dite PCMCIA de type III, et en ce que chacun desdits éléments est réalisé au moyen d'une carte dite PCMCIA de type II.

Ainsi, la présente invention permet de tirer le meilleur parti des formats de cartes et de fentes existants, pour offrir la fonctionnalité supplémentaire de lecteur de carte à mémoire, tout en utilisant des formats existants.

Suivant une autre caractéristique, une seule desdites cartes PCMCIA de type II est connectée audit appareil, et les communications éventuelles entre les deux cartes, nécessaires à la réalisation de la fonction modem, se font par l'intermédiaire d'un autre élément appelé module de raccordement.

Ainsi l'interêt de l'invention est encore accru par le fait qu'il n'est pas nécessaire de modifier les moyens de connexion à prévoir sur ledit appareil pour pouvoir être équipé d'un modem suivant l'invention, par rapport au cas d'un modem réalisé, suivant l'art antérieur, au moyen d'une carte PCMCIA de type III (étant entendu que les moyens de connexion prévus sur une carte PCMCIA sont identiques et placés au même endroit sur cette carte, que cette carte soit de type II ou de type III).

Suivant une autre caractéristique, chacune des cartes PCMCIA de type II est munie d'un connecteur placé sur sa tranche, et en ce que ces deux cartes PCMCIA de type II sont montées tête-bêche, de façon à ce que le connecteur de celle qui n'est pas connectée audit appareil permette de la connecter audit module de raccordement.

Ainsi une rigidité mécanique est en outre conférée à l'ensemble, sans qu'il soit nécessaire de prévoir des moyens particuliers à cette fin.

Suivant une autre caractéristique, ledit module de raccordement est constitué par un module revêtant la forme d'une excroissance de l'une desdites cartes, dépassant de ladite fente à l'état inséré dudit module, et destinée à contenir des circuits trop volumineux pour être contenus dans cette carte.

Ainsi l'invention permet encore une fois de tirer le meilleur parti d'éléments existants pour offrir une fonctionnalité nouvelle à moindre coût.

D'autres objets et caractéristiques de la présente invention apparaîtront à la lecture de la description suivante d'un exemple de réalisation, faite en relation avec les dessins ci-annexés dans lesquels:
- la figure 1 représente schématiquement, à l'état non assemblé, les éléments formant un modem suivant l'invention, ainsi qu'une carte à mémoire destinée à être insérée dans le modem ainsi formé,
- la figure 2 représente schématiquement, à l'état assemblé, un modem suivant l'invention, une fois mis en place dans l'appareil qu'il équipe.

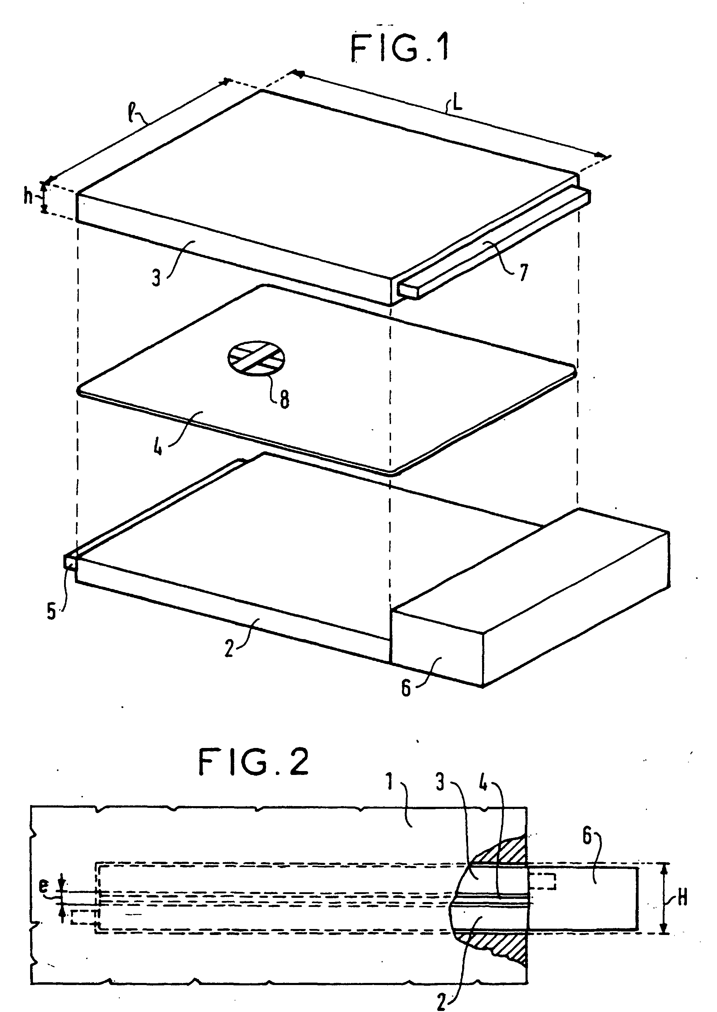

Dans l'exemple illustré sur les figures 1 et 2, l'appareil, noté 1 sur la figure 2, et destiné à être équipé d'un modem radio, est muni d'une fente de hauteur H adaptée pour recevoir un modem radio réalisé sous la forme d'une carte PCMCIA de type III, c'est-à-dire d'une carte PCMCIA d'épaisseur égale à 10,5 mm.

Dans cet exemple, ce modem radio comporte deux éléments, notés 2 et 3 sur les figures 1 et 2, réalisés chacun sous la forme d'une carte dite d'équipement, en l'occurrence une carte PCMCIA de type II se présentant donc sous la forme d'un boîtier ayant une longueur L et un largeur "1" analogues à celles d'une carte à mémoire telle que la carte à mémoire 4, et une épaisseur "h" en l'occurrence égale à 5 mm.

Chacun de ces boîtiers est apte à contenir des circuits nécessaires à la réalisation de la fonction modem, et est muni sur sa tranche d'un connecteur, tel que le connecteur 5 pour la carte 2, apte à raccorder ces circuits à des circuits extérieurs.

Dans l'exemple illustré, le connecteur 5 est destiné à être connecté à un connecteur complémentaire (non visible, à l'état monté, sur la figure 2) prévu dans ladite fente.

En outre, dans l'exemple illustré, l'une de ces cartes, en l'occurrence la carte 2, est pourvue d'un module distinct, noté 6, revêtant la forme d'une excroissance dépassant de ladite fente à l'état inséré dudit modem, et contenant des circuits trop volumineux pour être logés dans la carte 2, en l'occurrence des circuits réalisant la partie radio de la fonction modem, les parties conversion de fréquence et traitement en bande de base étant par contre réalisées par des circuits logeables à l'intérieur de la carte 2.

Dans cet exemple, la carte 3 est disposée tête-bêche par rapport à la carte 2, et le connecteur 7 dont est muni la carte 3 est ainsi utilisé pour fixer cette carte au module 6, qui est alors muni en correspondance d'un connecteur complémentaire (non visible, à l'état monté, sur la figure 2, et non visible non plus, du fait de la représentation en perspective, sur la figure 1).

Dans cet exemple, la répartition des circuits réalisant lesdites fonctions de conversion de fréquence et de traitement en bande de base, entre les cartes 2 et 3, pouvant a priori être quelconque, une communication entre ces cartes peut être nécessaire. Une telle communication se fait alors avantageusement par l'intermédiaire du module 6 (appelé aussi de ce fait module de raccordement)et des connecteurs placés ainsi en correspondance sur la carte 3 et le module 6.

A l'état assemblé, les cartes 2 et 3 sont ainsi disposées en regard l'une de l'autre, avec un léger espacement entre elles, noté "e" sur la figure 2, destiné à permettre l'insertion, entre ces deux cartes, d'une carte à mémoire telle que la carte 4.

En munissant en outre l'ensemble ainsi obtenu de moyens, connus par ailleurs, notamment dans le domaine des terminaux téléphoniques GSM, pour réaliser les fonctions aussi bien mécaniques qu'électriques nécessaires à la préhension de cette carte et à la lecture des informations portées par cette carte, on obtient ainsi un lecteur de carte à mémoire.

Dans l'exemple illustré, l'insertion d'une carte à mémoire dans ce lecteur de carte se fait ainsi à l'état non encore inséré dudit modem, ce modem muni de cette carte à mémoire étant ensuite inséré dans l'appareil considéré.

Dans le cas où l'une des cartes 2 et 3 réalise à elle seule la fonction modem, ladite fonction de lecture des informations mémorisées dans la carte à mémoire 4 est avantageusement réalisée par l'autre de ces cartes.

Cette carte réalisant ladite fonction de lecture est en outre avantageusement la carte dite supérieure (carte 3 dans l'exemple illustré), c'est-à-dire la carte contre laquelle vient se placer la puce de silicium 8 équipant la carte à mémoire, dans le sens habituel d'utilisation de cette carte, c'est-à-dire avec cette puce orientée vers le haut.

On notera que de nombreuses variantes pourraient être apportées à l'invention ainsi décrite.

Notamment le module 6 pourrait (à condition de disposer de composants tous logeables à l'intérieur desdites cartes) ne pas être prévu, et les cartes 2 et 3 pourraient ne pas être montées tête-bêche, même si ceci ne permet pas alors de conférer de manière relativement simple une rigidité mécanique à l'ensemble, ainsi que de constituer une solution relativement simple pour assurer une communication éventuelle entre les cartes 2 et 3, et d'éviter d'avoir à modifier, par rapport au cas d'un modem formé par une carte PCMCIA de type III, les moyens de connexion (en l'occurrence le connecteur 7) à prévoir sur ledit appareil pour recevoir ledit modem.

## Revendications

1. Modem radio destiné à équiper un appareil (1) tel que notamment un ordinateur portable, ledit modem étant destiné à être inséré dans une fente prévue dans ledit appareil, ledit modem étant réalisé sous forme d'une carte dite carte d'équipement d'épaisseur déterminée et adaptée aux dimensions de la fente de l'appareil, la carte d'équipement d'épaisseur déterminée comportant deux éléments (2, 3), chacun réalisé au moyen d'une carte d'équipement d'épaisseur inférieure à ladite épaisseur déterminée, et ledit modem étant **caractérisé en ce que** les deux éléments (2, 3) sont d'une part disposés l'un par rapport à l'autre, et d'autre part équipés, de manière à former dans l'espacement (e) entre les éléments un lecteur de carte à mémoire.

2. Modem selon la revendication 1, **caractérisé en ce que** ladite épaisseur déterminée est celle d'une carte d'équipement dite PCMCIA de type III, et **en ce que** chacun desdits éléments est réalisé au moyen d'une carte d'équipement dite PCMCIA de type II.

3. Modem selon la revendication 2, **caractérisé en ce qu'** une seule desdites cartes PCMCIA de type II est connectée audit appareil, et **en ce que** les communications éventuelles entre ces deux cartes, nécessaires à la réalisation de la fonction modem, se font par l'intermédiaire d'un autre élément appelé module de raccordement (6).

4. Modem selon la revendication 3, **caractérisé en ce que** chacune desdites cartes PCMCIA de type II est munie d'un connecteur (5, 7) placé sur sa tranche, et **en ce que** ces deux cartes PCMCIA de type II sont montées tête-bêche, de façon à ce que le connecteur (7) de celle (3) qui n'est pas connectée audit appareil permette de la connecter audit module de raccordement (6).

5. Modem selon l'une des revendications 3 et 4, **caractérisé en ce que** ledit module de raccordement (6) est constitué par un module revêtant la forme d'une excroissance de l'une desdites cartes, dépassant de ladite fente à l'état inséré de ladite carte, et destinée à contenir des circuits trop volumineux pour être contenus dans cette carte.

## Patentansprüche

1. Funkmodem zur Ausstattung eines Geräts, insbesondere eines tragbaren Computers, wobei besagtes Modem dafür vorgesehen ist, in einen in besagtem Gerät vorgesehenen Schlitz eingelegt zu werden, wobei besagtes Modem in Form einer als Gerätekarte bezeichneten Karte aufgebaut ist, welche eine festgelegte Dicke aufweist und auf die Abmessungen des Schlitzes des Geräts abgestimmt ist, wobei die Gerätekarte von festgelegter Dicke zwei Elemente (2, 3) beinhaltet, von denen jedes mittels einer Gerätekarte einer geringeren als der festgelegten Dicke realisiert ist, und wobei besagtes Modem **dadurch gekennzeichnet ist, daß** die beiden Elemente (2, 3) einerseits im Verhältnis zueinander angeordnet und andererseits so ausgestattet sind, daß sie im Zwischenraum (e) zwischen den Elementen einen Speicherkartenleser bilden.

2. Modem gemäß Anspruch 1, **dadurch gekennzeichnet, daß** besagte festgelegte Dicke diejenige einer als PCMCIA-Karte vom Typ III bezeichneten Karte ist, sowie dadurch, daß jedes der besagten Elemente mittels einer als PCMCIA-Karte vom Typ II bezeichneten Gerätekarte realisiert ist.

3. Modem gemäß Anspruch 2, **dadurch gekennzeichnet, daß** eine einzige der besagten PCMCIA-Karten vom Typ II mit besagtem Gerät verbunden ist, sowie dadurch, daß Kommunikationsvorgänge, die zwischen diesen beiden Karten zur Realisierung der Modemfunktion gegebenenfalls erforderlich sind, mittels eines anderen, als Anschlußmodul (6) bezeichneten Elements bewerkstelligt werden.

4. Modem gemäß Anspruch 3, **dadurch gekennzeichnet, daß** jede der besagten PCMCIA-Karten vom Typ II an ihrer Kante mit einem Steckverbinder (5, 7) ausgestattet ist, sowie dadurch, daß diese beiden PCMCIA-Karten vom Typ II derart entgegengesetzt zueinander montiert sind, daß der Steckverbinder (7) der nicht mit dem Gerät verbundenen Karte (3) das Anschließen dieser Karte an das besagte Anschlußmodul (6) gestattet.

5. Modem gemäß einem oder beiden der Ansprüche 3 und 4, **dadurch gekennzeichnet, daß** das besagte Anschlußmodul (6) aus einem Modul besteht, das die Form einer Erweiterung einer der besagten Karten aufweist, im eingelegten Zustand der Karte über den besagten Schlitz hinausragt und zur Bestückung mit Schaltungen vorgesehen ist, die zu voluminös sind, um auf dieser Karte untergebracht zu werden.

## Claims

1. A radio modem for fitting to equipment (1) such as a portable computer, in particular, said modem being deigned to be inserted in a slot provided in said equipment, said modem being in the form of an "equipment" card of determined thickness, and adapted to the dimensions of the slot of the equipment, the equipment card of determined thickness including two elements (2, 3) each implemented by means of an equipment card of thickness that is smaller than said determined thickness, and said modem being **characterized in that** the two elements (2, 3) are disposed relative to each other and are fitted so as to form a memory card reader in the space (e) between the elements.

2. A modem according to claim 1, **characterized in that** said determined thickness is the thickness of an "equipment" card of PCMCIA type III, and **in that** each of said elements is implemented by means of an "equipment" card of PCMCIA type II.

3. A modem according to claim 2, **characterized in that** only one of said PCMCIA type II cards is connected to said equipment, and **in that** any connection required between said two cards for the purpose of performing the modem function takes place via another element referred to as a connector module (6).

4. A modem according to claim 3, **characterized in that** each of said PCMCIA type II cards is provided with a connector (5, 7) placed along its edge, and **in that** said two PCMCIA type II cards are mounted head to tail so that the connector (7) of the card (3) which is not connected to said equipment can be used to connect it to said connection module (6).

5. A modem according to claim 3 or 4, **characterized in that** said connection module (6) is constituted by a module that is in the form of a projection on one of said cards that sticks out from said slot when said card is in the inserted state, and that is designed to contain circuits that are too bulky to be contained in said card.
